# EUROPEAN PATENT SPECIFICATION

(11) **EP 1 243 902 B1**
(45) Date of publication and mention of the grant of the patent: **02.11.2005**
(21) Application number: 02006074.5
(22) Date of filing: 18.03.2002
(51) Int. Cl.: G01J 3/06, B81B 3/00, G02B 26/00

(54) **Spectrophotometer with electrostatic microshutters**
Spektrophotometer mit electrostatischen Mikroverschlüssen
Spectrophotomètre comportant des micro-obturateurs

(30) Priority: 23.03.2001 IT TO010275
(43) Date of publication of application: 25.09.2002
(73) Proprietor: C.R.F. Società Consortile per Azioni, 10043 Orbassano (Torino) (IT)
(72) Inventor: Pizzi, Marco, 10100 Torino (IT)
(74) Representative: Notaro, Giancarlo

(56) References cited:
- EP-A- 1 008 885
- WO-A-86/01626
- DE-A- 3 047 495
- GB-A- 2 328 015
- US-A- 5 305 083

## Description

The present invention relates to the field of spectrophotometers, of the type indicated in the pre-characterizing portion of any of claims 1,3 and 4. A device of this type is disclosed in US-A-5 305 083.

According to prior art, the aforesaid sensor means are typically composed of a matrix of sensors.

The object of the invention is to produce a spectrophotometer of the type indicated above that has a simpler and low cost structure which is also efficient and reliable.

With a view to attaining this object, the invention relates to a spectrophotometer having all the features indicated in claim 1 or claim 3 or claim 4.

The electrostatic microshutters can be produced according to prior art already developed by the applicant and proposed for example in the prior European patent application EP-A-1 008 885. According to said prior art a common substrate is provided on which an electrically conductive lamina forming a first electrode is applied, in turn coated with a layer of transparent dielectric material. The first electrode deposited over the substrate is composed of non-transparent material, and provided with an opening corresponding to each petal, through which light may pass. Analogously, the substrate is also produced in non-transparent material and has an opening corresponding to each microshutter. The substrate may be a few millimetres or centimetres thick and the first electrode may for example be a few tens or hundreds of nanometres thick. This first electrode can be applied for example by evaporation, or using the technique known as spin-coating, screen printing or dipping. The dielectric layer, which may also be applied by screen printing, spin-coating or dipping, can be for example from 0.1 micrometre to a few tens of micrometres thick. Movable petals are arranged over the dielectric layer, composed of a metal film about one micron thick, or dielectric for example also a few microns thick with a metallized layer facing the face of the dielectric layer acting as a second electrode. Each petal, in its undeformed condition, is curled up, so that light can pass through the substrate. By applying an electric voltage between the two electrodes of each microshutter, the petal uncurls, through electrostaticity, over the dielectric layer, to prevent light from passing through.

The use of the line of electrostatic microshutters consents the selection of a single wavelength desired in the light beam delivered from the separator element, which makes it possible to utilize a single sensor, to the advantage of the simplicity of the entire device.

In a variant, the shutter device comprises two surfaces facing and at a distance from each other bearing two aligned series of first electrodes, and an electrically conductive film the ends of which are connected rigidly to the two facing surfaces, at ends opposite each other of the aligned series of first electrodes. By supplying the electrodes selectively, it is possible to make the film interposed between the two facing surfaces take an S-shape, with a first portion adhering to a first surface, a second portion adhering to a second surface and an intermediate portion connecting these portions. The film can also be provided with a diagonally aligned arrangement of micro-windows, so that only one of these micro-windows is each time in line with the aforesaid S-shaped connecting portion of the film, according to the method with which the electrodes on the two facing surfaces are supplied.

Further characteristics and advantages shall become more apparent from the description below with reference to the accompanying drawings, provided purely as a non-limiting example, in which:
Figure 1 is a schematic view of a spectrophotometer according to the invention,
Figure 2 is a partially sectional view of an example of an electrostatic microshutter device not falling within the scope of the invention,
Figure 3 shows a first embodiment of an electrostatic microshutter device according to the invention,
Figure 4 shows a second embodiment of the electrostatic microshutter device,
Figure 5 is a view according to the line V of Figure 4,
Figure 6 is a view developed in a plane of the film utilized in the device in Figures 4, 5,
Figure 7 is a schematic perspective view of the film in Figure 6 in its operating condition, and
Figure 8 is a schematic perspective view of a variant.

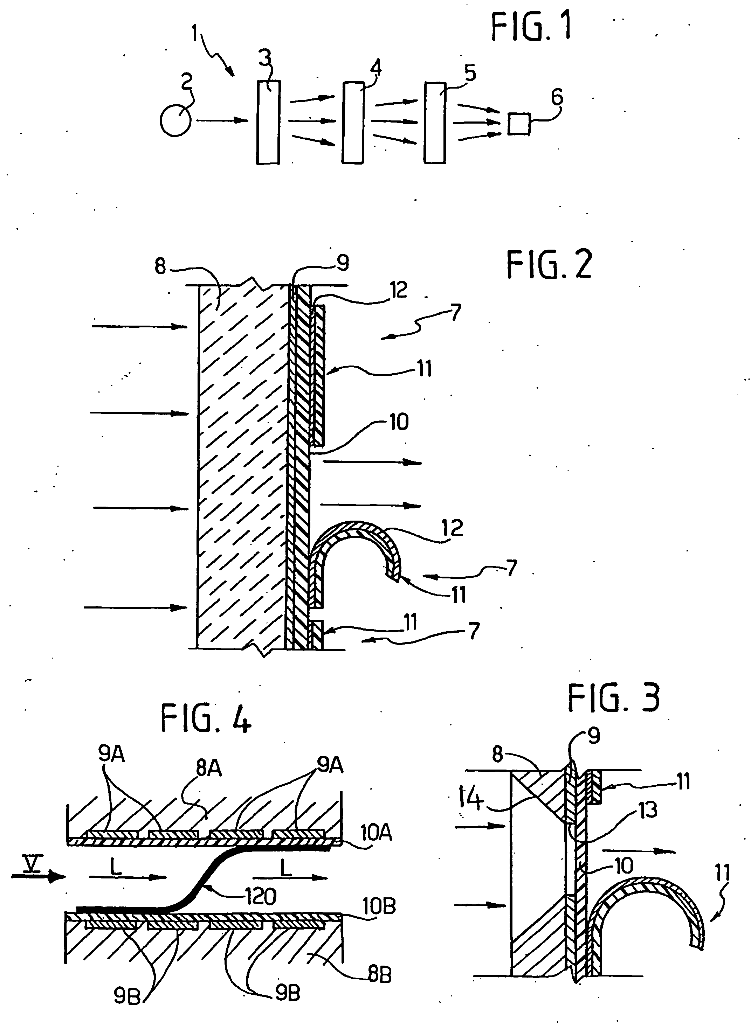

In Figure 1, number 1 indicates as a whole the spectrophotometer according to the invention, comprising a light source 2, a separator element 3 of any known type, suitable to separate the light beam emitted by the source 2 into its components corresponding to different wavelengths. Arranged downstream of the separator device 3 is an electrostatic microshutter device 4 illustrated in detail below. This device is suitable to select a single wavelength desired in the beam emitted from the separator element 3. The radiation emitted is then caused to converge by an optical element 5 over a single sensor 6, of any known type, suitable to emit an output electric signal that operates from the light energy received.

Figure 2 shows an example of the electrostatic microshutter device 5 not falling within the scope of the invention. According to this example, an aligned series of microshutters 7 with a movable petal are provided, arranged over a substrate 8, for example composed of a transparent material such as germanium, silicon, quartz or glass, a few millimetres or centimetres thick. Applied over the substrate 8 is a film 9 in transparent conductive material, such as ITO (Indium Tin Oxide), a few tens or hundreds of nanometres thick, obtained for example by evaporation, spin-coating, screen printing or dipping. The film 9 forms a first electrode of the device, which is then coated by a layer of transparent dielectric material 10, for example a few micrometres thick obtained with techniques similar to those utilized for the film 9. Arranged over the dielectric layer 10 is an aligned series of movable petals 11, each formed for example of a dielectric film applied to which is a metallized layer acting as a second electrode. Each petal 11 has one end anchored to the dielectric layer 10 and, in its undeformed condition, is curled up, so that light can pass through the respective portion of the substrate. The device comprises electric supply means to apply a difference in potential between the first electrode 9 and the second electrode 12 of a selected petal 11. After voltage has been applied, the petal uncurls over the dielectric layer 10 adhering to it through electrostaticity, and consequently preventing light from passing through the respective portion of the substrate. By controlling the electric supply to the electrostatic microshutters 7 of the aligned series of microshutters, it is thus possible to select a single wavelength desired in the radiation delivered from the separator element 3.

Figure 3 shows a first embodiment of the electrostatic microshutter device in which the electrode 9 can be in a non-transparent, low cost metal material, in which case a micro-window 13 is provided corresponding to each petal 11. The substrate 8 can also be non-transparent and have an opening 14 corresponding to each petal.

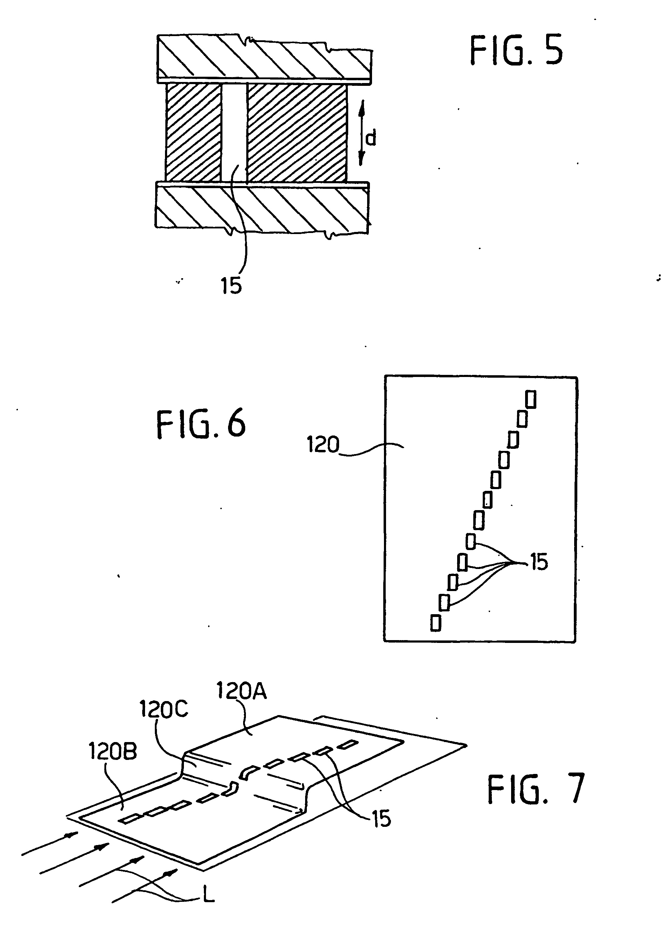

Figures 4-7 show a second embodiment. In this case two substrates 8A, 8B are provided with surfaces parallel to each other at a distance, arranged on each of which is an aligned series of first electrodes 9A, 9B, covered by respective dielectric layers 10A, 10B. Arranged between the two dielectric layers 10A, 10B is a film of conductive material 120 with its opposite ends anchored to the two layers 10A, 10B at opposite ends of the device.

As can be seen in Figure 4, a difference in potential is applied between the film 120 and some of the electrodes of the two series 9A, 9B, so that the film takes an S-shape (see also Figure 7) with two portions 120A, 120B that adhere to the two opposite layers 10A, 10B, and an intermediate connecting portion 120C that is substantially arranged perpendicularly to the two facing surfaces of the layers 10A, 10B. As can be seen in Figures 6, 7, a diagonally aligned arrangement of micro-windows 15 is obtained on the film 120. By controlling the supply to the electrodes 9A, 9B it is possible to make the film 120 uncurl progressively on one of the two layers 10A, 10B and move away from the other, so that the intermediate portion 120C travels from one end of the device to the other (from left to right or vice versa, with reference to Figure 4). Consequently, the micro-window 15 corresponding to the connecting portion 120c changes each time. With reference to Figure 5, this means that the position of the micro-window 15 that is visible from one end of the device moves from left to right or vice versa. When this device is applied to the spectrophotometer, the light rays emitted by the separator element 3 are directed parallel at the two opposite faces of the layers 10A, 10B, according to the arrows L in Figures 4, 7. Therefore, a variation of the S-shape of the film 120 determines a selection of the desired wavelength.

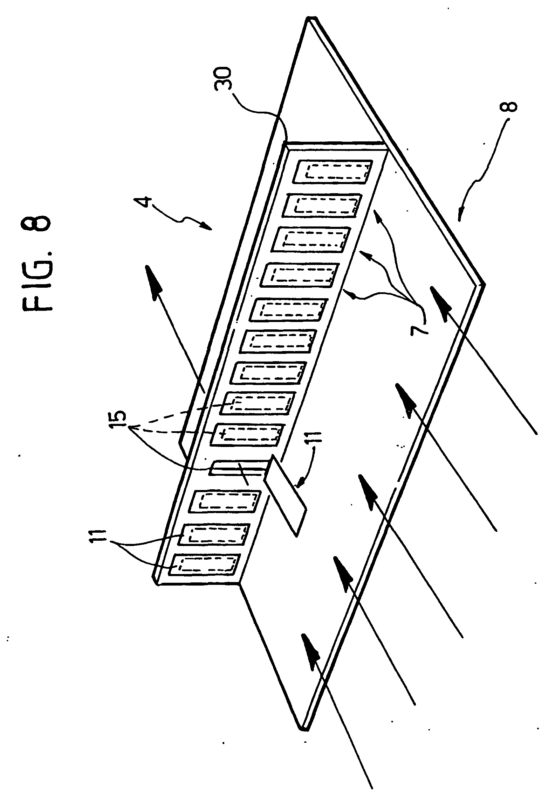

Figure 8 shows a variant in which a further electrode is provided for each microshutter, integrated in a strip support 30 arranged orthogonally to the layer 8 and bearing an array of micro-windows 15. The micro-window 15 is kept open by applying a voltage between each petal 11 and the electrode 9 associated with the layer 9. The micro-window is kept closed by applying a voltage between the petal 11 and the electrode associated with the support 30. Only one micro-window is kept open at a time to allow light to pass through, directed according to the arrows L.

## Claims

1. Spectrophotometer, comprising:
a light source (2),
a separator element (3) to separate the light beam coming from the light source (2) into its components corresponding to the different wavelengths.
sensor means (6) suitable to receive the radiations coming from the separator element (3) and to emit output electric signals indicating the wavelengths of the radiation received,
an aligned series of electrostatic microshutters interposed between the aforesaid separator element (3) and said sensor means (6),
**characterized in that** said sensor means are composed of a single sensor (6),
**in that** arranged downstream of the electrostatic microshutters (4) is an optical element (5) to cause the radiation to converge on said single sensor (6), and
**in that** said aligned series of electrostatic microshutters comprises a common substrate (8), applied to which is a film (9) forming a first electrode, coated by a layer of transparent dielectric material (10), said electrostatic microshutters (7) each comprising a movable petal (11) with a metallized layer (12) acting as second electrode, each petal (11) being in the shape of a curl in its condition at rest, in which the petal does not prevent light from passing (8), electric supply means provided to apply an electric voltage between said first electrode (9) and the electrode (12) of a selected petal (11), and
**in that** said first electrode (9) is composed of a non-transparent conductive material, with a micro-window (13) corresponding to each petal (11), and
**in that** said substrate (8) is composed of a non-transparent material with an opening (14) corresponding to each petal (11).

2. Spectrophotometer according to claim 1, **characterized in that** said substrate is between a few millimetres or centimetres thick, said first electrode (9) is a few tens or hundreds of nanometres thick, said dielectric layer (10) is from 0.1 micrometres to a few tens of micrometres thick.

3. Spectrophotometer, comprising:
a light source (2),
a separator element (3) to separate the light beam coming from the light source (2) into its components corresponding to the different wavelengths.
sensor means (6) suitable to receive the radiations coming from the separator element (3) and to emit output electric signals indicating the wavelengths of the radiation received,
an aligned series of electrostatic microshutters interposed between the aforesaid separator element (3) and said sensor means (6),
**characterized in that** said sensor means are composed of a single sensor (6),
**in that** arranged downstream of the electrostatic microshutters (4) is an optical element (5) to cause the radiation to converge on said single sensor (6), and
**in that** said aligned series of electrostatic microshutters comprises two substrates (8A), (8B), parallel to and facing each other, bearing respective aligned distributions of first electrodes (9A), (9B), and a film (120) forming the second electrode, arranged in an S-shape between the two substrates, with the opposite ends connected to the two substrates at their two opposite ends, electric supply means provided to apply a difference in potential between the aforesaid film and selected electrodes of the two series of electrodes (9A), (9B) carried by the two substrates, so that the film takes an S-shape, with two end portions adhering respectively to the two substrates and an intermediate connecting portion (120C), said film (120) having a diagonally aligned arrangement of micro-windows (15) so that only one of these micro-windows (15) corresponds to the connecting portion (120C) of the aforesaid S-shaped film.

4. Spectrophotometer comprising:
a light source (2),
a separator element (3) to separate the light beam coming from the light source (2) into its components corresponding to the different wavelengths.
sensor means (6) suitable to receive the radiations coming from the separator element (3) and to emit output electric signals indicating the wavelengths of the radiation received,
an aligned series of electrostatic microshutters interposed between the aforesaid separator element (3) and said sensor means (6),
**characterized in that** said sensor means are composed of a single sensor (6),
**in that** arranged downstream of the electrostatic microshutters (4) is an optical element (5) to cause the radiation to converge on said single sensor (6), and,
**in that** said aligned series of electrostatic microshutters comprises a common substrate (8) applied to which is a first electrode, a support (30) bearing an array of micro-windows (15) and a second electrode for each micro-shutter, and an array of petals (11) also with a conductive layer forming a further electrode, each suitable to adhere to the substrate (8) or to the support (30) through electrostaticity, depending on whether voltage is applied between the petal (11) and the first electrode (9) or between the petal (11) and the electrode associated with the support,
**in that** said second electrode is composed of a non-transparent conductive material, with a micro-window (15) corresponding to each petal (11), and
**in that** said support (30) is composed of a non-transparent material with an opening (14) corresponding to each petal (11).

## Patentansprüche

1. Spektrophotometer mit:
einer Lichtquelle (2),
ein Trennelement (3), um den von der Lichtquelle (2) kommenden Lichtstrahl in seine Komponenten, die den unterschiedlichen Wellenlängen entsprechen, zu trennen,
eine Sensoreinrichtung (6), welche geeignet ist, die von dem Trennelement (3) kommenden Strahlungen zu empfangen, und elektrische Ausgangssignale, welche die Wellenlängen der empfangenen Strahlung angeben, zu emittieren,
eine ausgerichtete Reihe von elektrostatischen Mikroverschlüssen, die zwischen dem Trennelement (3) und der Sensoreinrichtung (6) angeordnet sind,
**dadurch gekennzeichnet, dass** die Sensoreinrichtung aus einem einzelnen Sensor (6) besteht,
dass den elektrostatischen Mikroverschlüssen (4) nachgeschaltet ein optisches Element (5) angeordnet ist, um zu bewirken, dass die Strahlung an dem einzelnen Sensor (6) zusammenläuft, und
dass die ausgerichtete Reihe von elektrostatischen Mikroverschlüssen ein gemeinsames Substrat (8) aufweist, an dem ein Film (9) vorgesehen ist, der eine erste Elektrode bildet, die mit einer Schicht eines transparenten dielektrischen Materials (10) beschichtet ist, wobei jeder der elektrostatischen Mikroverschlüsse (7) ein bewegliches Blatt (11) mit einer metallisierten Schicht (12), die als zweite Elektrode wirkt, aufweist, wobei jedes Blatt (11) in seinem Ruhezustand, in dem das Blatt (11) Licht nicht daran hindert, (8) zu passieren, in der Form einer Locke ist, wobei eine elektrische Versorgungseinrichtung vorgesehen ist, um eine elektrische Spannung zwischen der ersten Elektrode (9) und der Elektrode (12) von einem ausgewählten Blatt (11) anzulegen, und
dass die erste Elektrode (9) aus einem nicht-transparenten, leitenden Material, mit einem Mikrofenster (13), dass jedem Blatt (11) entspricht, besteht, und
dass das Substrat (8) aus einem nicht-transparenten Material mit einer Öffnung (14), die jedem Blatt (11) entspricht, besteht.

2. Spektrophotometer nach Anspruch 1, **dadurch gekennzeichnet, dass** das Substrat zwischen ein paar Millimetern oder Zentimetern dick ist, die erste Elektrode (9) wenige Zehntel-oder Hundertstel-Nanometer dick ist, die dielektrische Schicht (10) von 0,1 Mikrometern bis zu wenigen Zehntel-Mikrometern dick ist.

3. Spektrophotometer mit:
einer Lichtquelle (2),
ein Trennelement (3), um den von der Lichtquelle (2) kommenden Lichtstrahl in seine Komponenten, die den unterschiedlichen Wellenlängen entsprechen, zu trennen,
eine Sensoreinrichtung (6), welche geeignet ist, die von dem Trennelement (3) kommenden Strahlungen zu empfangen, und elektrische Ausgangssignale, welche die Wellenlängen der empfangenen Strahlung angeben, zu emittieren,
eine ausgerichtete Reihe von elektrostatischen Mikroverschlüssen, die zwischen dem Trennelement (3) und der Sensoreinrichtung (6) angeordnet sind,
**dadurch gekennzeichnet, dass** die Sensoreinrichtung aus einem einzelnen Sensor (6) besteht,
dass den elektrostatischen Mikroverschlüssen (4) nachgeschaltet ein optisches Element (5) angeordnet ist, um zu bewirken, dass die Strahlung an dem einzelnen Sensor (6) zusammenläuft, und
dass die ausgerichtete Reihe von elektrostatischen Mikroverschlüssen zwei Substrate (8A, 8B) aufweist, die parallel zueinander sind und einander gegenüber liegen, wobei sie jeweils ausgerichtete Verteilungen von ersten Elektroden (9A, 9B), und einen Film (120) tragen, der die zweite Elektrode bildet, wobei er in einer S-Form zwischen den zwei Substraten angeordnet ist, die entgegengesetzten Enden mit den zwei Substraten an deren zwei entgegengesetzten Enden verbunden sind, wobei eine elektrische Versorgungseinrichtung vorgesehen ist, um ein unterschiedliches Potential zwischen dem Film und ausgewählten Elektroden der zwei Reihen von Elektroden (9A, 9B) anzulegen, die derart von den zwei Substraten getragen werden, dass der Film eine S-Form annimmt, wobei die zwei Endabschnitte jeweils an den zwei Substraten und einem Zwischenverbindungsabschnitt (120C) anhaften, wobei der Film (120) eine diagonal ausgerichtete Anordnung von Mikrofenstern (15) aufweist, so dass lediglich eines dieser Mikrofenster (15) dem Verbindungsabschnitt (120C) des S-förmigen Films entspricht.

4. Spektrophotometer mit:
einer Lichtquelle (2),
ein Trennelement (3), um den von der Lichtquelle (2) kommenden Lichtstrahl in seine Komponenten, die den unterschiedlichen Wellenlängen entsprechen, zu trennen,
eine Sensoreinrichtung (6), welche geeignet ist, die von dem Trennelement (3) kommenden Strahlungen zu empfangen, und elektrische Ausgangssignale, welche die Wellenlängen der empfangenen Strahlung angeben, zu emittieren,
eine ausgerichtete Reihe von elektrostatischen Mikroverschlüssen, die zwischen dem Trennelement (3) und der Sensoreinrichtung (6) angeordnet sind,
**dadurch gekennzeichnet, dass** die Sensoreinrichtung aus einem einzelnen Sensor (6) besteht,
dass den elektrostatischen Mikroverschlüssen (4) nachgeschaltet ein optisches Element (5) angeordnet ist, um zu bewirken, dass die Strahlung an dem einzelnen Sensor (6) zusammenläuft, und
dass die ausgerichtete Reihe von elektrostatischen Mikroverschlüssen ein gemeinsames Substrat (8) aufweist, an dem eine erste Elektrode, eine Stütze (30), die eine Gruppierung von Mikrofenstern (15) und eine zweite Elektrode für jeden Mikroverschluss trägt, und eine Gruppierung von Blättern (11) vorgesehen sind, auch mit einer leitenden Schicht, die eine weitere Elektrode bildet, wobei jede geeignet ist, an dem Substrat (8) oder an der Stütze (30) durch Elektrostatizität anzuhaften, die davon abhängt, ob eine Spannung zwischen dem Blatt (11) und der ersten Elektrode (9), oder zwischen dem Blatt (11) und der der Stütze zugehörigen Elektrode, angelegt ist,
dass die zweite Elektrode aus einem nicht-transparenten, leitenden Material, mit einem Mikrofenster (15), dass jedem Blatt (11) entspricht, besteht, und
dass die Stütze (30) aus einem nicht-transparenten Material mit einer Öffnung (14), die jedem Blatt (11) entspricht, besteht.

## Revendications

1. Spectrophotomètre comportant:
une source de lumière (2),
un élément diviseur (3) servant à diviser le faisceau de lumière arrivant de la source de lumière (2) en ses composantes correspondant aux différentes longueurs d'onde,
des moyens formant capteur (6) convenant pour recevoir les rayonnements provenant de l'élément diviseur (3) et émettre des signaux de sortie électriques indiquant les longueurs d'onde du rayonnement reçu,
une série de micro-obturateurs électrostatiques alignés, qui sont intercalés entre l'élément diviseur (3) mentionné précédemment et lesdits moyens formant capteur (6),
**caractérisé en ce que** lesdits moyens formant capteur sont constitués par un capteur unique (6), **en ce qu'**en aval des micro-obturateurs électroniques (4) est disposé un élément optique (5) servant à amener le rayonnement à converger sur ledit capteur unique (6), et
**en ce que** ladite série de micro-obturateurs électrostatiques alignés comprend un substrat commun (8), sur lequel est appliqué un film (9) formant une première électrode, recouverte par une couche d'un matériau diélectrique transparent (10), lesdits micro-obturateurs électrostatiques (7) comprenant chacun un pétale mobile (11) comportant une couche métallisée (12) agissant en tant que seconde électrode, chaque pétale (11) ayant la forme d'une boucle dans son état au repos, dans lequel le pétale empêche le passage de la lumière (8), des moyens d'alimentation électrique prévus pour appliquer une tension électrique entre ladite première électrode (9) et l'électrode (12) d'un pétale sélectionné (11),
**en ce que** ladite première électrode (9) est constituée par un matériau conducteur non transparent comportant une micro-fenêtre (13) correspondant à chaque pétale (11), et
**en ce que** ledit substrat (8) est constitué d'un matériau non transparent comportant une ouverture (14) correspondant à chaque pétale (11).

2. Spectrophotomètre selon la revendication 1, **caractérisé en ce que** ledit substrat possède une épaisseur comprise entre quelques millimètres ou centimètres, ladite première électrode (9) comprenant une épaisseur comprise entre quelques dizaines ou quelques centaines de nanomètres et ladite couche diélectrique (10) possédant une épaisseur comprise entre 0,1 nanomètre et quelques dizaines de nanomètres.

3. Spectrophotomètre comprenant:
une source de lumière (2),
un élément diviseur (3) servant à diviser le faisceau de lumière arrivant de la source de lumière (2) en ses composantes correspondant aux différentes longueurs d'onde,
des moyens formant capteur (6) convenant pour recevoir les rayonnements provenant de l'élément diviseur (3) et émettre des signaux de sortie électriques indiquant les longueurs d'onde du rayonnement reçu,
une série de micro-obturateurs électrostatiques alignés, qui sont intercalés entre l'élément diviseur (3) mentionné précédemment et lesdits moyens formant capteur (6),
**caractérisé en ce que** lesdits moyens formant capteur sont constitués par un capteur unique (6),
**en ce qu'**en aval des micro-obturateurs électroniques (4) est disposé un élément optique (5) servant à amener le rayonnement à converger sur ledit capteur unique (6), et
**en ce que** ladite série de micro-obturateurs électrostatiques alignés comprend deux substrats (8A), (8B), qui sont disposés en parallèle en vis-à-vis l'un de l'autre et portent des distributions alignées respectives de premières électrodes (9A), (9B), et un film (120) formant la seconde électrode, agencé avec une forme en S entre les substrats, les extrémités opposés étant raccordées aux deux substrats au niveau de leurs deux extrémités opposées, des moyens d'alimentation électrique prévus pour appliquer une différence de potentiel entre le film mentionné précédemment et des électrodes sélectionnées et deux séries d'électrodes (9A), (9B) portées par les deux substrats, de sorte que le film possède une forme en S, avec deux parties d'extrémité qui adhèrent respectivement aux deux substrats et une partie de raccordement intermédiaire (120C), ledit film (120) possédant un agencement aligné en diagonale de micro-fenêtres (15) de sorte que seule l'une de ces micro-fenêtres (15) correspond à la partie de raccordement (120C) du film en forme de S mentionné précédemment.

4. Spectrophotomètre comprenant:
une source de lumière (2),
un élément diviseur (3) servant à diviser le faisceau de lumière arrivant de la source de lumière (2) en ses composantes correspondant aux différentes longueurs d'onde,
des moyens formant capteur (6) convenant pour recevoir les rayonnements provenant de l'élément diviseur (3) et émettre des signaux de sortie électriques indiquant les longueurs d'onde du rayonnement reçu,
une série de micro-obturateurs électrostatiques alignés, qui sont intercalés entre l'élément diviseur (3) mentionné précédemment et lesdits moyens formant capteur (6),
**caractérisé en ce que** lesdits moyens formant capteur sont constitués d'un seul capteur (6),
**en ce qu'**en aval des micro-obturateurs électrostatiques (4) est disposé un élément optique (5) servant à faire converger le rayonnement sur ledit capteur unique (6),
**en ce que** ladite série de micro-obturateurs électrostatiques alignés comprend un substrat commun (8), sur lequel est appliquée une première électrode, un support (30) portant un réseau de micro-fenêtres (15) et une seconde électrode pour chaque micro-obturateur et un réseau de pétales (11) comportant également une couche conductrice formant une autre électrode, chacune étant appropriée pour adhérer au substrat (8) ou au support (30) par voie électrostatique, en fonction de la tension qui est appliquée entre le pétale (11) et la première électrode (9) ou entre le pétale (11) et l'électrode associée au support, **en ce que** ladite seconde électrode est constituée par un matériau conducteur non transparent, avec une micro-fenêtre (15) correspondant à chaque pétale (11) et **en ce que** ledit support (30) est composé d'un matériau non transparent comportant une ouverture (14) correspondant à chaque pétale (11).
